# EUROPÄISCHE PATENTSCHRIFT

(11) **EP 2 208 080 B1**
(45) Veröffentlichungstag und Bekanntmachung des Hinweises auf die Patenterteilung: **19.10.2016**
(21) Anmeldenummer: 08802229.8
(22) Anmeldetag: 16.09.2008
(51) Int. Cl.: G01R 31/36

(54) **SCHALTUNGSANORDNUNG MIT EINER AKKUMULATORKASKADE**
CIRCUIT ARRANGEMENT HAVING BATTERY CASCADE
CIRCUIT ÉLECTRIQUE AVEC UNE CASCADE D'ACCUMULATEURS

(30) Priorität: 07.11.2007 DE 102007052929
(43) Veröffentlichungstag der Anmeldung: 21.07.2010
(73) Patentinhaber: Braun GmbH, 61476 Kronberg/Taunus (DE)
(72) Erfinder: FRANKE, Michael, 64291 Darmstadt (DE); RIEMER, Jörn, 61381 Friedrichsdorf (DE); SCHÄDEL, Tobias, 61350 Bad Homburg (DE)
(74) Vertreter: Zetterer, Gerd
(86) Internationale Anmeldenummer: PCT/EP2008/007695
(87) Internationale Veröffentlichungsnummer: WO 2009/059657

(56) Entgegenhaltungen:
- EP-A- 0 828 304
- DE-A1- 4 132 229
- DE-A1-102005 041 824

## Beschreibung

Die Erfindung betrifft eine Schaltungsanordnung mit einer Akkumulatorkaskade gemäß dem Oberbegriff des Anspruchs 1.

Schaltungsanordnungen mit einer Akkumulatorkaskade werden typischerweise verwendet, um Unterschiede in der Aufladung der einzelnen Akkumulatoren der Akkumulatorkaskade zu unterbinden und um so eine vorzeitige Degradation eines Akkumulators zu verhindern.

Eine Schaltungsanordnung mit einer Akkumulatorkaskade ist in der Patentschrift DE 39 40 929 C1 beschrieben, bei der eine Steuerschaltung nacheinander Schalterpaare, die jeweils den Polanschlüssen eines Akkumulators der Akkumulatorkaskade zugeordnet sind, schließt und so den jeweiligen Akkumulator mit parallel geschalteten Kapazitäten verbindet. Je nach Spannungsunterschied zwischen den Kondensatoren und dem an sie angeschlossenen Akkumulator findet ein Ladungsaustausch und Ladungsausgleich statt. Jedem Akkumulator ist eine Vergleichsschaltung zugeordnet, die die am jeweiligen Akkumulator anliegende Ist-Spannung mit einer Soll-Spannung vergleicht und mit der Differenzspannung die Steuerschaltung beaufschlagt. Um zu einem Ladungsausgleich zu kommen, wird zuerst das Schalterpaar eines besser aufgeladenen Akkumulators geschlossen und die Kondensatoren werden aufgeladen bis die Spannung des besser aufgeladenen Akkumulators an ihnen anliegt. Danach wird das Schalterpaar geöffnet und das Schalterpaar eines schlechter aufgeladenen Akkumulators wird geschlossen. Dann fließt Ladung aus den Kondensatoren in den schlechter aufgeladenen Akkumulator.

Nachteil der beschriebenen Schaltungsanordnung ist, dass sie für die Messung der einzelnen Akkumulatorspannungen jeweils eine Vergleichsschaltung pro Akkumulator und für den Ladungsausgleich eine zusätzliche Schaltung mit mehreren Kondensatoren benötigt.

Aus der EP 0 282 304 A2 ist ein Spannungs-Steuergerät für eine Speicherbatterie mit mehreren Batteriezellen nach dem Oberbegriff des Anspruchs 1 bekannt. Über jeder Batteriezelle und einem Kondensator zugeordnete Schalter ist es möglich, eine erste Seite des Kondensators über einen Widerstand mit dem Pluspol des ersten Akkumulators zu koppeln.

Die DE 41 32 229 A1 beschreibt eine Microcontroller-gesteuerte Einrichtung zur Optimierung des Ladezustands einer mehrzelligen Batterie, welche eine Einrichtung zur schaltbaren Verbindung auswählbarer Klemmspannungen von Teilbatterien oder Zellen mit einer Messeinrichtung aufweist.

In der DE 10 2005 041 824 A1 sind eine Vorrichtung und ein Verfahren zum Ladungsausgleich zwischen den Einzelzellen eines Doppelschichtkondensators beschrieben, wobei jeder Einzelzelle ein Kondensator zugeordnet ist, dessen erster Anschluss über einen ersten Schalter mit dem ersten Anschluss der zugeordneten Zelle und über einen zweiten Schalter mit dem zweiten Anschluss der zugeordneten Zelle verbunden werden kann.

Aufgabe der vorliegenden Erfindung ist es, eine Schaltungsanordnung und ein Verfahren zur Verfügung zu stellen, bei dem mit einfacher Schaltungsanordnung ein präzises Messen der Spannungen in einer Akkumulatorkaskade möglich ist und auch ein Ladungsausgleich zwischen unterschiedlich geladenen Akkumulatoren möglich ist,

Die Aufgabe wird durch eine Schaltungsanordnung mit den Merkmalen gemäß Anspruch 1 und ein Verfahren mit den Merkmalen gemäß Anspruch 10 gelöst. In den abhängigen Ansprüchen sind Weiterbildungen angegeben.

Bei der Schaltungsanordnung nach Anspruch 1 wird erreicht, dass die Messung der Spannung am zweiten Akkumulator der Akkumulatorkaskade dadurch ermöglicht wird, dass die Spannung des ersten Akkumulators im Kondensator speicherbar ist und so die Differenz zwischen der Spannung, die an der gesamten Akkumulatorkaskade anliegt und der Spannung, die am Kondensator anliegt, gegen ein Grundpotential gemessen werden kann. Dies erspart, dass jedem Akkumulator ein unabhängiger Messschaltkreis zugeordnet werden muss, und es erlaubt außerdem, dass ein Messschaltkreis verwendet werden kann, der nicht für die Gesamtspannung an der Akkumulatorkaskade ausgelegt ist, da nur die Differenzspannung gegen ein Grundpotential gemessen werden muss und nicht die Differenz der Spannungswerte an den Polen des zweiten Akkumulators gegen das Grundpotential. Typische Spannungswerte für eine Akkumulatorkaskade aus Lithiu6m-Ionen-Akkumulatoren wäre etwa 4.0 Volt (V) am Pluspol des ersten Akkumulators und 8.0 V am Pluspol des zweiten Akkumulators. Die Spannung, die am zweiten Akkumulator liegt, muss in der vorliegenden Schaltungsanordnung nicht als Differenz von 8.0 V gegen Grundpotential und 4.0 V gegen Grundpotential gemessen werden, sondern die Differenzspannung von 4.0 V kann direkt gegen Grundpotential gemessen werden.

In einer weiteren Ausführungsform der Schaltungsanordnung ist ein Messschaltkreis vorhanden, der die Spannung, die am ersten Akkumulator anliegt, direkt über einen ersten Eingang zugeführt bekommen kann und ein zweiter Eingang des Messschaltkreises kann die Differenzspannung zwischen der Spannung am Kondensator im aufgeladenen Zustand und der Gesamtspannung der Akkumulatorkaskade zugeführt bekommen. Aufgrund der Eigenschaften der Schaltungsanordnung kann hierbei ein Messschaltkreis, etwa ein handelsüblicher und kostengünstiger Mikrocontroller, der auf eine maximale Spannung von etwa 5.5 V ausgelegt ist, verwendet werden.

In einer anderen Ausführungsform hat der Messschaltkreis einen Analog-Digital-Wandler, mit dem zugeführte analoge Spannungswerte in digitale Spannungswerte gewandelt werden können und einen Speicher. Digitale Spannungswerte können im Speicher gespeichert werden, um etwa gegeneinander verglichen zu werden oder um einen Zeitverlauf der Spannungsentwicklung für eine spätere Analyse zur Verfügung zu stellen. Der Analog-Digital-Wandler kann ein analoges Signal sowohl vom ersten Eingang oder dem zweiten Eingang des Messschaltkreises zugeführt bekommen; es ist daher nicht notwendig, dass zwei Analog-Digital-Wandler vorgesehen werden und bei nur einem Analog-Digital-Wandler unterliegt jede Wandlung dem gleichen Fehler, sodass sich bei Differenzbildung zweier gewandelter Werte der Fehler im Wesentlichen heraussubtrahiert. Der Speicher kann entweder als Speicher für einen digitalen Wert ausgelegt sein oder als Speicher für eine Vielzahl von digitalen Werten.

In einer Ausführungsform weist der Messschaltkreis noch eine Vergleichseinheit auf, die dazu dient, einen zuvor bestimmten Spannungswert mit einem aktuellen Spannungswert zu vergleichen.

In einer weiteren Ausführungsform ist der erste Schalter und der zweite Schalter durch den Messschaltkreis kontrollierbar.

In einer anderen Ausführungsform ist der Pluspol des zweiten Akkumulators über einen dritten Schalter mit dem Messschaltkreis koppelbar. Derart kann der Messschaltkreis über die Akkumulatorkaskade mit Energie versorgt werden.

In einer Ausführungsform hat der Messschaltkreis eine interne Referenzspannung. Dies erlaubt die absolute Messung der Spannungswerte, was insbesondere ermöglicht, dass das Erreichen einer Unterspannung oder eine Überspannung an den jeweiligen Akkumulatoren festgestellt werden kann. Ferner erlaubt eine Referenzspannung auch eine Messung mit hoher Genauigkeit.

In einer weiteren Ausführungsform ist die Akkumulatorkaskade mit einer Ladeschaltung verbunden, sodass die Ladung der Akkumulatoren mittels der Ladeschaltung erfolgen kann. Die Ladeschaltung kann von dem Messschaltkreis kontrollierbar sein, sodass bei Erreichen einer Unterspannung automatisch ein Laden der Akkumulatoren stattfinden kann.

Die beschriebene Schaltungsanordnung kommt insbesondere bei Elektrogeräten, die durch Akkumulatoren versorgt werden, zum Einsatz. Solche Elektrogeräte sind insbesondere Mobiltelefone, elektrische Zahnbürsten, Rasierer oder Epilierer, kabellos betriebene Haushaltsgeräte wie Stabmixer oder kabellos betriebene Werkzeuge wie Akkuschrauber. Die Erfindung betrifft daher auch ein Elektrogerät, dass eine solche Schaltungsanordnung aufweist.

Die Erfindung betrifft weiterhin ein Verfahren zum Messen einer Spannung in einer Akkumulatorkaskade. Das Verfahren besteht aus den Schritten:
- Laden eines Kondensators, der an einem Grundpotential anliegt, aus einem ersten, an dem Grundpotential liegenden Akkumulator einer Akkumulatorkaskade, bis die Spannung, die an dem ersten Akkumulator anliegt auch mit einer gewünschten Präzision an dem Kondensator anliegt.
- Entkoppeln des Kondensators vom Grundpotential, wobei dies insbesondere dadurch geschieht, dass zwischen den Kondensator und das Grundpotential ein Widerstand mit hoher Impedanz (etwa mehrer Megaohm) geschaltet wird.
- Anlegen der Gesamtspannung der Akkumulatorkaskade an den Kondensator, sodass die Differenz der am Kondensator anliegenden Spannung und der Gesamtspannung gegen das Grundpotential messbar ist.

In Weiterbildungen dieses Verfahrens wird eine Teilentladung des zweiten Akkumulators über einen Widerstand durchgeführt oder bei einer Ladung der Akkumulatoren wird der Ladestrom, der dem zweiten Akkumulator zugeführt wird, teilweise über einen Widerstand geführt. Dies erlaubt bei festgestellter höherer Spannung am zweiten Akkumulator gegen die Spannung am ersten Akkumulator, dass der zweite Akkumulator über den Widerstand teilentladen wird oder durch ein Abführen von Ladestrom langsamer geladen wird als der erste Akkumulator, bis sich die Spannungen angeglichen haben.

In einer anderen Weiterbildung des Verfahrens wird ein Messschaltkreis nur über den ersten Akkumulator versorgt. Dies sorgt bei einer festgestellten höheren Spannung am ersten Akkumulator gegenüber der Spannung am zweiten Akkumulator, dass sich der erste Akkumulator wegen der Versorgung des Messschaltkreises schneller entlädt als der zweite Akkumulator, sodass die Spannungen angeglichen werden können.

Die Erfindung wird im Weiteren durch Diskussion exemplarischer Ausführungsbeispiele und in Bezug auf Figuren detailliert erläutert. Hierbei ist in den Figuren
- Fig. 1: eine Schaltungsanordnung zur Messung der Spannungen in einer Akkumulatorkaskade,
- Fig. 2: eine Schaltungsanordnung, die gegenüber Fig. 1 um zusätzliche Komponenten erweitert wurde und
- Fig. 3: eine schematische Darstellung eines Elektrogerätes, das eine Schaltungsanordnung aufweist.

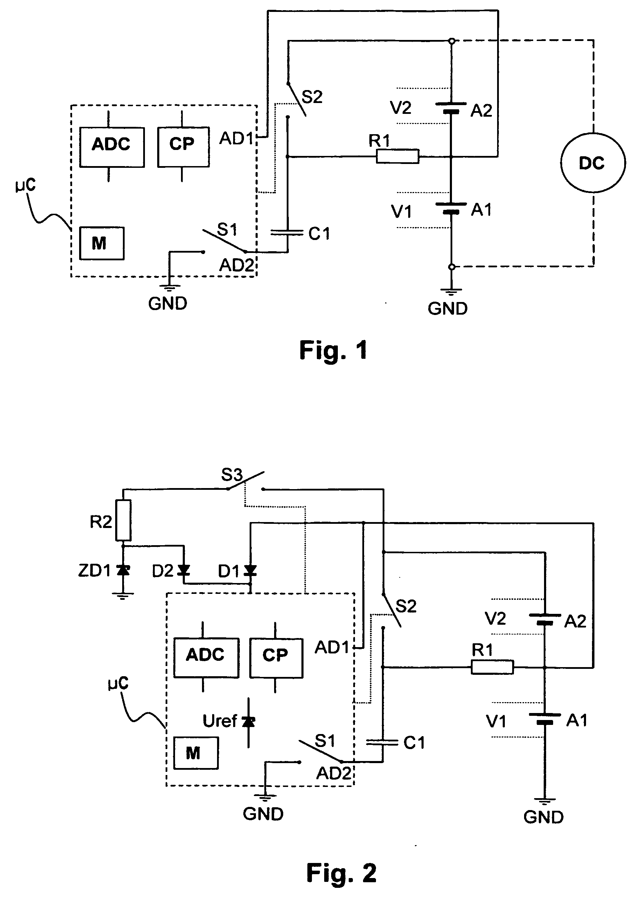

Die Schaltungsanordnung nach Fig. 1 weist eine Akkumulatorkaskade auf, die einen ersten Akkumulator A1 und einen zweiten Akkumulator A2 hat. An dem ersten Akkumulator A1 liegt dabei die Spannung V1 an und an dem zweiten Akkumulator A2 die Spannung V2. Die Spannungswerte werden durch den jeweiligen Ladezustand der Akkumulatoren bestimmt. Der Minuspol des ersten Akkumulators A1 ist mit einem Grundpotential verbunden, etwa dem Erd-Potential oder einem anderen Massepotential. Der Pluspol des ersten Akkumulators A1 ist sowohl mit dem Minuspol des zweiten Akkumulators A2 verbunden, als auch mit einem Widerstand R1. Der Widerstand R1 ist mit einem Kondensator C1 verbunden, der wiederum über einen ersten Schalter S1 im geschlossenen Zustand des ersten Schalters S1 an dem Grundpotential liegt. Der Pluspol des zweiten Akkumulators A2 ist über einen zweiten Schalter S2 zwischen den Kondensator C1 und den Widerstand R1 eingekoppelt. Gestrichelt ist ein Messschaltkreis µC angedeutet. Dem Messschaltkreis µC können analoge Spannungswerte zur Messung den ersten Eingang AD1 und den zweiten Eingang AD2 zugeführt werden. Die Akkumulatorkaskade kann in an sich bekannter Weise mit einer Ladeschaltung DC verbunden werden, bei der eine Entladung der Akkumulatorkaskade über die Ladeschaldung DC nicht erfolgen kann, wohl aber ein Laden der Akkumulatorkaskade erfolgen kann. Der Messschaltkreis µC dient auch der Steuerung des zweiten Schalters S2, was durch eine gepunktete Linie angedeutet ist. Der erste Schalter S1 ist hier als Bestandteil des Messschaltkreises µC ausgeführt und der Kondensator ist Grundpotentialseitig an den zweiten Eingang AD2 des Messschaltkreises gekoppelt. Der erste Schalter S1 kann aber auch ein externer, vom Messschattkreis µC gesteuerter Schalter sein. Damit eine hohe Präzision der Schaltung erreicht wird, kann der zweite Schalter S2 insbesondere als ein Schalter mit geringem (oder praktisch keinem) Spannungsabfall realisiert sein, etwa als FET oder MOS-FET.

Handelt es sich bei den Akkumulatoren um Lithium-Ionen-Akkumulatoren, können die Spannungen V1 und V2 im Betriebzustand je nach Ladungszustand einen Wert von etwa 2.5 - 4.2 Volt (V) annehmen. Ein Abgriff am Pluspol des ersten Akkumulators A1 ermöglicht die direkte Messung der Spannung V1, die am ersten Akkumulator A1 anliegt. Ein solcher Abgriff ist hier mit dem ersten Eingang AD1 des Messschaltkreises µC verbunden. Der Messschaltkreis µC kann den zugeführten analogen Spannungswert etwa mittels eines Analog-Digital-Wandlers ADC in einen digitalen Spannungswert wandeln, wobei ein 10-Bit Analog-Digital-Wandler eine Genauigkeit von etwa einem Tausendstel der Referenzspannung ermöglicht. Der digitale Spannungswert kann in einem Speicher M des Messschaltkreises µC für weitere Verwendung gespeichert werden, etwa für einen Spannungswertevergleich (wie im Weiteren beschrieben) oder für die Bereitstellung eines Zeitverlaufs der Spannung V1. Die gezeigte Schaltungsanordnung ermöglicht verschiedene Verwendungsarten, die im Folgenden beschrieben werden. Dabei handelt es sich um die Verwendung
a) als Schaltungsanordnung zur Messung der Spannungen der Akkumulatorkaskade und
b) als Schaltungsanordnung zur Nivellierung der Ladezustände des ersten und des zweiten Akkumulators.

Die Funktion der Schaltungsanordnung nach Fig. 1 in der Verwendung a) ist wie folgt. Zuerst wird über den Abgriff am Pluspol des ersten Akkumulators A1 die am ersten Akkumulator A1 anliegende Spannung V1 dem Messschaltkreis µC an dem ersten Eingang AD1 zugeführt. Der erste Eingang AD1 wird einem Analog-Digital-Wandler ADC des Messschaltkreises µC zugeführt, der den analogen Spannungswert in einen digitalen Spannungswert wandelt, wobei der Analog-Digital-Wandler ADC in der beschriebenen Ausführungsform eine Auflösung von 10 Bit hat, sodass eine Genauigkeit von etwa 4 mV erreicht werden kann, da die maximale aufzulösende Spannung der Maximalspannung des Lithium-Ionen-Akkumulators entspricht. In einem nächsten Schritt wird der erste Schalter S1 geschlossen und der zweite Schalter S2 wird geöffnet. Dann lädt der erste Akkumulator A1 den Kondensator C1 über den Widerstand R1 auf. Durch geeignete Dimensionierung des Kondensators C1 (Kapazität C) und des Widerstands R1 (Ohmscher Widerstand R) kann eine Ladezeitkonstante T, die sich aus dem Produkt von Kapazität C des Kondensators C1 und Ohmschen Widerstand R des Widerstands R1 ergibt, T = R·C, definiert werden, durch die erreicht wird, dass die Spannung, die am Kondensator C1 anliegt, innerhalb eine Ladezeit von wenigen Millisekunden mit einer Präzision von etwa 0.1 % (was der Größenordnung entspricht, mit der der Analog-Digital-Wandler ADC die Spannungswerte digitalisiert) der Spannung V1, die am ersten Akkumulator A1 anliegt, entspricht. Durch längere oder kürzere Ladezeit kann eine höhere oder geringere Präzision der Spannungswertübereinstimmung erreicht werden. Wenn die so gewünschte Präzision der Spannung an dem Kondensator C1 erreicht ist, wird der erste Schalter S1 geöffnet, sodass ein Entladen des Kondensators C1 im Wesentlichen unterbunden ist (der zweite Eingang hat bei geöffnetem ersten Schalter S1 eine sehr hohe Impedanz im Megaohm-Bereich (MΩ)) und nur die geringen Leckströme über den Isolationswiderstand des Kondensators C1 zu einer langsamen Entladung des Kondensators C1 führen. Der zweite Schalter S2 wird dann geschlossen, sodass dem zweiten Eingang AD2 des Messschaltkreises µC ein Spannungswert zugeführt wird, der der Differenz zwischen der Summenspannung der Spannung V1 am ersten Akkumulator A1 und der Spannung V2 am zweiten Akkumulator A2 und der Spannung V1' am Kondensator C1 (V1' ≈ V1) entspricht, also kann eine Spannung V = (V1+V2) - V1' = V2' gegen das Grundpotential gemessen werden. Die am zweiten Eingang AD2 anliegende Spannung V entspricht dann also der Spannung V2 mit einer Genauigkeit, die durch die Genauigkeit der Spannung V1' am Kondensator C1 in Bezug auf die Spannung V1 am ersten Akkumulator A1 gegeben ist. Durch Erhöhen der Ladezeit des Kondensators C1 kann die Präzision dieser Spannung erhöht werden. Dadurch, dass der Kondensator C1 bei geöffnetem ersten Schalter S1 praktisch nicht entladen wird (was durch die Auswahl eines Kondensators mit entsprechend guter Qualität gewährleistet werden kann) und die Spannungsmessung im Wesentlichen ohne Zeitverzug nach dem Schließen des zweiten Schalters S2 gemessen werden kann, ist eine Selbstentladung des Kondensators C1 auch unerheblich für die Präzision der Spannungsmessung. Der am zweiten Eingang AD2 anliegende Spannungswert wird einem Analog-Digital-Wandler ADC zugeführt, um den analogen Spannungswert in einen digitalen Spannungswert zu wandeln. Der Analog-Digital-Wandler ADC ist hier der gleiche, dem auch über den ersten Eingang AD1 ein Spannungswert zugeführt wird; der Messschaltkreis µC könnte aber auch mehrere Analog-Digital-Wandler aufweisen.

Unter der Voraussetzung, dass die Versorgungsspannung des Messschaltkreises µC (die in der in Fig. 1 beschriebenen Ausführungsform von einer externen Spannungsquelle bereit gestellt wird) konstant bleibt, kann ein relativer Vergleich zwischen dem gespeicherten ersten digitalen Spannungswert, der der Spannung V1 am ersten Akkumulator A1 entspricht, und dem zweiten digitalen Spannungswert, der der Spannung V2 am zweiten Akkumulator entspricht, vorgenommen werden, etwa mittels einer Vergleichseinheit CP des Messschaltkreises µC. Ein Unterschied in den verglichenen Spannungen deutet darauf hin, dass einer der beiden Akkumulatoren stärker entladen ist als der andere. Entsprechende Schritte zur Nivellierung des Ladungszustandes des ersten Akkumulators A1 und des zweiten Akkumulators A2 können dann erfolgen.

Stellt der Messschaltkreis µC eine interne konstante Referenzspannung Uref (siehe Fig. 2) zur Verfügung, können die Spannungswerte auch absolut miteinander verglichen werden und es kann insbesondere festgestellt werden, ob sich die Spannungswerte einem kritischen unteren Spannungswert nähern, der einer nahezu vollständigen Entladung des entsprechenden Akkumulators entspricht. Notwendige Schritte, um eine vollständige Entladung zu vermeiden, können dann eingeleitet werden (was in bekannter Weise ein Anzeigen einer Entladungswarnung und/oder ein Nichtversorgen der eigentlichen Last des Gerätes sein kann). Es kann bei der Ladung der Akkumulatoren auch festgestellt werden, ob sich die jeweilige Spannung an den Akkumulatoren einem kritischen oberen Wert nähert und die Ladung der Akkumulatoren kann dann gestoppt werden. Eine Referenzspannung kann natürlich auch extern zur Verfügung gestellt werden.

Die beschriebene Schaltungsanordnung erlaubt, einen Messschaltkreis µC zu verwenden, der nicht für die Summenspannung V = V1+V2 der Spannung V1 des ersten Akkumulators A1 und der Spannung V2 des zweiten Akkumulators A2 ausgelegt ist. Als Messschaltkreis kann daher ein Mikrocontroller verwendet werden, der für einen Maximalspannung von etwa 5.5 V ausgelegt ist, wobei die Summenspannung V = V1+V2 bei voll geladenen Akkumulatoren etwa 8.4 V beträgt. Die Schaltungsanordnung erlaubt auch die präzise (relative und/oder absolute) Messung der Spannungen an den Akkumulatoren in der Akkumulatorkaskade und einen präzisen Vergleich der beiden Spannungen V1 und V2. Da während der Messungen keine Ströme über den Kondensator C1 fließen, sind die Übergangswiderstände des ersten Schalters S1 und des zweiten Schalters S2 irrelevant und es können preisgünstige Komponenten eingesetzt werden. Im Wesentlichen ist nur bei dem Kondensators C1 auf höhere Qualität der Komponente zu achten. So kann etwa ein Papier- oder Kunststofffolienkondensator mit hohem Isolationswiderstand eingesetzt werden, um die Selbstentladung des Kondensators C1, der hier als Speicher für einen Spannungswert verwendet wird, sehr gering zu halten.

Die Funktion der Schaltungsanordnung nach Fig. 1 in der Verwendung b) ist wie folgt. Ist durch den Vergleich der Spannungen festgestellt worden, dass die Spannung V2 am zweiten Kondensator A2 größer ist die Spannung V1 am ersten Kondensator, V2 > V1, so kann ein Ladungsausgleich dermaßen stattfinden, dass der zweite Schalter S2 geschlossen wird und der zweite Akkumulator über den Widerstand R1 entladen wird. Da der Messschaltkreis µC in einer Ausführungsform regelmäßig die Messung der Spannungswerte durchführt, kann die Teilentladung des zweiten Akkumulators A2 über den Widerstand R1 durch Öffnen des zweiten Schalter beendet werden, wenn die Spannung V2 am zweiten Akkumulator gleich der Spannung V1 am ersten Akkumulator A1 ist, V2 = V1. Befindet sich das Gerät im Ladevorgang, dann bedingt das Schließen des zweiten Schalters S2, dass ein Teil des Stromes über den Widerstand R1 fließt und nicht durch den zweiten Akkumulator A2, sodass der erste Akkumulator A1 schneller aufgeladen wird als der zweite Akkumulator A2 und es so zu einer Egalisierung der Spannungswerte V2 am zweiten Akkumulator A2 und V1 am ersten Akkumulator A1 kommt. Auch während der Ladung der Akkumulatoren kann der Messschaltkreis µC die Spannungswerte V1 und V2 messen und entsprechend den zweiten Schalter öffnen oder schließen. Wird festgestellt, dass die Spannung V1 am ersten Akkumulator A1 größer ist als die Spannung V2 am zweiten Akkumulator, V1 > V2, dann kann der erste Akkumulator zur Versorgung des Messschaltkreises µC verwendet werden, sodass der erste Akkumulator A1 mit Strömen im Milliampere-Bereich (mA) durch die Versorgung des Messschaltkreises µC entladen wird, wohingegen eine Selbstentladung im Ruhemodus des Akkumulators ohne Versorgung einer Last im Mikroampere-Bereich (µA) liegt. Dies wird im Folgenden mit Bezug auf Fig. 2 beschrieben.

In der Schaltungsanordnung nach Fig. 2 sind grundsätzlich die gleichen Komponenten enthalten wie in Fig. 1, weshalb auf die Beschreibung von Fig. 1 bezüglich dieser Komponenten verwiesen wird. Die Schaltungsanordnung nach Fig. 2 ist gegenüber der Schaltungsanordnung nach Fig. 1 allerdings erweitert. Der Pluspol des ersten Akkumulators ist über eine erste Diode D1 mit einem Versorgungseingang des Messschaltkreises µC verbunden. Weiterhin ist der Pluspol des zweiten Akkumulators A2 über einen dritten Schalter S3 mit einem weiteren Widerstand R2 verbunden. Der dritte Schalter S3 ist durch den Messschaltkreis µC kontrollierbar, was durch eine gepunktete Linie angedeutet ist. Der weitere Widerstand R2 liegt über eine Zener-Diode an dem Grundpotential an und der weitere Widerstand R2 ist über eine zweite Diode D2 mit dem Versorgungseingang des Messschaltkreises µC verbunden. Diese Schaltungsanordnung erlaubt eine dritte Verwendung der Schaltungsanordnung, nämlich die Versorgung des Messschaltkreises µC durch die Akkumulatorkaskade. Der Messschaltkreis µC hat auch eine interne Referenzspannung Uref, die - wie im Zusammenhang mit Fig. 1 bereits erwähnt - dazu verwendet werden kann, die zugeführten Spannungswerte absolut zu messen, sodass das Erreichen einer Unterspannung erkannt werden kann und so die Akkumulatoren gegen die Unterspannung geschützt werden können, was die Lebensdauererwartung eines Akkumulators erhöht.

In der Ausführungsform nach Fig. 2 wird der Messschaltkreis µC über die Akkumulatoren versorgt. Bei geschlossenem drittem Schalter S3 wird der Messschaltkreis µC von beiden Akkumulatoren der Akkumulatorkaskade über die zweite Diode D2 versorgt. Der weitere Widerstand R2 und die Zener-Diode ZD1 sind so gewählt, dass der Messschaltkreis µC auch bei einer Summenspannung beider Akkumulatoren, die über der Betriebsspannung des Messschaltkreises µC (etwa 5.5 V) liegt, nur mit einer Spannung versorgt wird, für die der Messschaltkreis µC ausgelegt ist. Durch die Versorgung mittels beider Akkumulatoren der Akkumulatorkaskade kann der Messschaltkreis auch dann noch volle Leistung erbringen, wenn sich die Spannungen der Akkumulatoren jeweils der Unterspannungsgrenze von etwa 2.5 V nähern. Weiterhin kann der Messschaltkreis µC auch bei einer großen Belastung der Akkumulatoren durch die zu versorgende Last des Gerätes (nicht gezeigt; bei einem Rasierer oder einem Haushaltsgerät handelt es sich bei der Last typischerweise um einen Motor) zuverlässig versorgt werden, da die dann auftretenden Spannungseinbrüche durch die große Last nicht zu einer Unterversorgung des Messschaltkreises µC führen. Wie bereits im Zusammenhang mit Fig. 1 erwähnt, kann der Messschaltkreis µC bei einer Spannung V1 des ersten Akkumulators A1, die größer ist als die Spannung V2 des zweiten Akkumulators A2, V1 > V2, auch nur über den ersten Akkumulator A1 versorgt werden. Dazu wird der dritte Schalter S3 geöffnet. Auch im Stand-by-Betrieb des Gerätes wird der Messschaltkreis µC über die erste Diode D1 versorgt, wobei der dritte Schalter S3 geöffnet bleibt. In dieser Betriebsart ist die Spannungsreglung über den weiteren Widerstand R2 und die Zener-Diode ZD1 nicht notwendig und es werden nur wenige Mikroampere (µA) verbraucht.

Durch die beschriebene Schaltungsanordnung wird eine hohe Messpräzision von wenigen Millivolt ohne die Verwendung von kostenintensiven Komponenten ermöglicht. Tatsächlich kann ein preiswerter, handelsüblicher Mikrocontroller als Messschaltkreis µC eingesetzt werden.

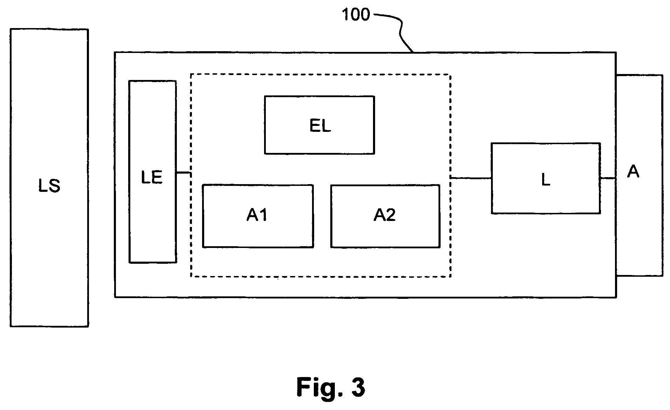

In Fig. 3 ist schematisch ein Elektrogerät 100 gezeigt, das eine erfindungsgemäße Schaltungsanordnung aufweist. Die Schaltungsanordnung besteht aus dem ersten Akkumulator A1, dem zweiten Akkumulator A2 und den elektronischen Komponenten EL. Die Akkumulatoren versorgen eine Last L des Elektrogerätes 100. Eine solche Last kann etwa ein Motor sein, der dann ein Anwendungsmittel A antreibt. Ein solches Anwendungsmittel A ist etwa ein Scherblatt bei einem Elektrorasierer, eine Pinzettenwalze bei einem Epilierer, ein Bohrkopf bei einem Elektrobohrer oder ein Schneidmesser bei einem Pürierstab. Bei einem Mobiltelefon kann die Last aus dem Display und der Sende- und Empfängereinheit bestehen. Die Akkumulatoren des Elektrogerätes 100 können über eine Ladestation LS in an sich bekannter Weise durch induktive Ladung oder mittels direkter Kontaktierung geladen werden. Dazu enthält das Elektrogerät 100 eine Ladelektronik LE.

## Patentansprüche

1. Schaltungsanordnung, die geeignet ist, die jeweiligen Spannungen an den Akkumulatoren einer Akkumulatorkaskade zu messen, mit
∘ einem ersten Akkumulator (A1), dessen Minuspol an einem Grundpotential (GND) liegt,
∘ einem zweiten Akkumulator (A2), dessen Minuspol mit dem Pluspol des ersten Akkumulators gekoppelt ist, und
∘ einem Kondensator (C1), der an seiner ersten Seite über einen Widerstand (R1) mit dem Pluspol des ersten Akkumulators (A1) gekoppelt ist,
**dadurch gekennzeichnet, dass** der Kondensator (C1) mit seiner zweiten Seite über einen ersten Schalter (S1) an das Grundpotential (GND) anlegbar ist,
wobei der Pluspol des zweiten Akkumulators (A2) über einen zweiten Schalter (S2) in die Verbindung zwischen den Widerstand (R1) und der ersten Seite des Kondensators (C1) eingekoppelt ist.

2. Schaltungsanordnung nach Anspruch 1, die zusätzlich einen Messschaltkreis (µC) zur Auswertung der gemessenen Spannungen aufweist, wobei der Pluspol des ersten Akkumulators (A1) mit einem ersten Eingang (AD1) des Messschaltkreises (µC) gekoppelt ist und die zweite Seite des Kondensator (C1) mit einem zweiten Eingang (AD2) des Messschaltkreises (µC) gekoppelt ist.

3. Schaltungsanordnung nach Anspruch 2, wobei der Messschaltkreis (µC) einen Analog-Digital-Wandler (ADC) zur Digitalisierung zugeführter analoger Spannungswerte aufweist und einen Speicher (M) zur Speicherung mindestens eines digitalisierten Spannungswertes.

4. Schaltungsanordnung nach Anspruch 2 oder Anspruch 3, wobei der Messschaltkreis (µC) eine Vergleichseinheit (CP) zum Vergleichen zweier Spannungswerte aufweist.

5. Schaltungsanordnung nach einem der Ansprüche 2 bis 4, wobei der erste Schalter (S1) und der zweite Schalter (S2) durch den Messschaltkreis (µC) kontrolliert werden.

6. Schaltungsanordnung nach einem der Ansprüche 2 bis 5, wobei der Pluspol des zweiten Akkumulators (A2) über einen dritten Schalter (S3) mit dem Messschaltkreis (µC) koppelbar ist.

7. Schaltungsanordnung nach einem der Ansprüche 2 bis 6, wobei der Messschaltkreis (µC) eine interne Referenzspannung (Uref) zur Absolutbestimmung von Spannungswerten hat.

8. Schaltungsanordnung nach einem der Ansprüche 1 bis 7, wobei der Minuspol des ersten Akkumulators (A1) und der Pluspol des zweiten Akkumulators (A2) mit einer Ladeschaltung (DC) gekoppelt sind oder an eine Ladeschaltung (DC) koppelbar sind.

9. Elektrogerät (100) mit einer Schaltungsanordnung nach einem der Ansprüche 1 bis 9, wobei die Akkumulatorkaskade zur Versorgung einer Last (L) des Elektrogerätes (100) dient.

10. Verfahren zum Bereitstellen einer Spannung, die ein Maß ist für eine Spannung an einem Akkumulator in einer Akkumulatorkaskade gemäß Ansprunch 1, bei dem die folgenden Schritte durchgeführt werden:
• Laden eines an einem Grundpotential liegenden Kondensators (C1) bis die Spannung (V1) eines an dem Grundpotential (GND) liegenden ersten Akkumulators (A1) der Akkumulatorkaskade mit vorgegebener Präzision an dem Kondensator (C1) anliegt,
• Entkoppeln des Kondensators (C1) vom Grundpotential (GND), insbesondere durch Schalten einer hohen Impedanz zwischen Kondensator (C1) und Grundpotential (GND),
• Anlegen der Summenspannung aus der Spannung (V1) des ersten Akkumulators (A1) und der Spannung (V2) eines zweiten Akkumulators (A2) der Akkumulatorkaskade an den Kondensator (C1).

11. Verfahren nach Anspruch 10, wobei als weiterer Schritt eine Teilentladung des zweiten Akkumulators (A2) über einen Widerstand (R1) durchgeführt wird.

12. Verfahren nach Anspruch 10, wobei als weiterer Schritt bei einer Beladung der Akkumulatorkaskade ein Teil des Ladestroms beim zweiten Akkumulators (A2) über einen Widerstand (R1) geführt wird.

13. Verfahren nach einem der Ansprüche 10 bis 12, wobei als weiterer Schritt die Versorgung eines Messschaltkreises (µC) nur über den ersten Akkumulator (A1) durchgeführt wird.

## Claims

1. Circuit arrangement that is suitable to measure the respective voltages at the accumulators of an accumulator cascade, with
∘ a first accumulator (A1) whose negative terminal is at the ground potential (GND),
∘ a second accumulator (A2) whose negative terminal is coupled with the positive terminal of the first accumulator, and
∘ a capacitor (C1) that is coupled on its first side via a resistor (R1) with the positive terminal of the first accumulator (A1),
**characterized in that** the ground potential (GND) can be applied to the capacitor (C1) with its second side via a first switch (S1),
wherein, via a second switch (S2), the positive terminal of the second accumulator (A2) is coupled between the resistor (R1) and the first side of the capacitor (C1).

2. Circuit arrangement according to Claim 1 that additionally has a measurement circuit (µC) for the evaluation of the measured voltages, wherein the positive terminal of the first accumulator (A1) is coupled with a first input (AD1) of the measurement circuit (µC), and the second side of the capacitor (C1) is coupled with a second input (AD2) of the measurement circuit (µC).

3. Circuit arrangement according to Claim 2, wherein the measurement circuit (µC) has an analog/digital converter (ADC) to digitize supplied analog voltage values, and a memory (M) to store at least one digitized voltage value.

4. Circuit arrangement according to Claim 2 or Claim 3, wherein the measurement circuit (µC) has a comparator (CP) to compare two voltage values.

5. Circuit arrangement according to any of the Claims 2 through 4, wherein the first switch (S1) and the second switch (S2) are monitored by the measurement circuit (µC).

6. Circuit arrangement according to any of the Claims 2 through 5, wherein the positive terminal of the second switch (A2) can be coupled with the measurement circuit (µC) via a third switch (S3).

7. Circuit arrangement according to any of the Claims 2 through 6, wherein the measurement circuit (µC) has an internal reference voltage (Uref) for absolute determination of voltage values.

8. Circuit arrangement according to any of the Claims 1 through 7, wherein the negative terminal of the first accumulator (A1) and the positive terminal of the second accumulator (A2) are coupled with a charging circuit (DC) or can be coupled to a charging circuit (DC).

9. Electrical device (100) with a circuit arrangement according to any of the Claims 1 through 9, wherein the accumulator cascade serves to supply a load (L) of the electrical device (100).

10. Method to provide a voltage that is a measure of a voltage at an accumulator in an accumulator cascade according to Claim 1, in which method the following steps are implemented:
∘ charge a capacitor (C1) at a ground potential until the voltage (V1) of a first accumulator (A1) of the accumulator cascade, said accumulator (A1) being at the ground potential (GND), is applied to the capacitor (C1) with predetermined precision,
∘ decouple the capacitor (C1) from the ground potential (GND), in particular by switching a high impedance between capacitor (C1) and ground potential (GND),
∘ apply the sum voltage of the voltage (V1) of the first accumulator (A1) and the voltage (V2) of a second accumulator (A2) of the accumulator cascade to the capacitor (C1).

11. Method according to Claim 10, wherein a partial discharge of the second accumulator (A2) via a resistor (R1) is implemented as an additional step.

12. Method according to Claim 10, wherein, given a charging of the accumulator cascade, a portion of the charge current at the second accumulator (A2) is directed via a resistor (R1) as an additional step.

13. Method according to any of the Claims 10 through 12, wherein the supply of a measurement circuit (µC) is implemented only via the first accumulator (A1) as an additional step.

## Revendications

1. Circuiterie, appropriée pour mesurer les différentes tensions aux accumulateurs d'une cascade d'accumulateurs, présentant
∘ un premier accumulateur (A1), dont le pôle négatif se situe à un potentiel de masse (GND),
∘ un deuxième accumulateur (A2), dont le pôle négatif est couplé au pôle positif du premier accumulateur et
∘ un condensateur (C1), qui est couplé, au niveau de son premier côté, via une résistance (R1) au pôle positif du premier accumulateur (A1),
caractérisé ce que le condensateur (C1) peut être mis au potentiel de masse (GND) au niveau de son deuxième côté via un premier commutateur (S1),
dans laquelle le pôle positif du deuxième accumulateur (A2) est couplé via un deuxième commutateur (S2) dans la liaison entre la résistance (R1) et le premier côté du condensateur (C1).

2. Circuiterie selon la revendication 1, qui présente en outre un circuit de mesure (µC) pour l'évaluation des tensions mesurées, le pôle positif du premier accumulateur (A1) étant couplé à une première entrée (AD1) du circuit de mesure (µC) et le deuxième côté du condensateur (C1) étant couplé à une deuxième entrée (AD2) du circuit de mesure (µC).

3. Circuiterie selon la revendication 2, dans laquelle le circuit de mesure (µC) présente un convertisseur analogique-numérique (CAD) pour la numérisation des valeurs de tension analogiques introduites et une mémoire (M) pour l'enregistrement d'au moins une valeur de tension numérisée.

4. Circuiterie selon la revendication 2 ou la revendication 3, dans laquelle le circuit de mesure (µC) présente une unité de comparaison (CP) pour la comparaison de deux valeurs de tension.

5. Circuiterie selon l'une quelconque des revendications 2 à 4, dans laquelle le premier commutateur (S1) et le deuxième commutateur (S2) sont commandés par le circuit de mesure (µC).

6. Circuiterie selon l'une quelconque des revendications 2 à 5, dans laquelle le pôle positif du deuxième accumulateur (A2) peut être couplé via un troisième commutateur (S3) au circuit de mesure (µC).

7. Circuiterie selon l'une quelconque des revendications 2 à 6, dans laquelle le circuit de mesure (µC) présente une tension de référence interne (Uref) pour la détermination absolue des valeurs de tension.

8. Circuiterie selon l'une quelconque des revendications 1 à 7, dans laquelle le pôle négatif du premier accumulateur (A1) et le pôle positif du deuxième accumulateur (A2) sont couplés à un circuit de charge (DC) ou peuvent être couplés à un circuit de charge (DC).

9. Appareil électrique (100) présentant une circuiterie selon l'une quelconque des revendications 1 à 9, dans laquelle la cascade d'accumulateurs sert à alimenter une charge (L) de l'appareil électrique (100).

10. Procédé pour la mise à disposition d'une tension, qui est une mesure pour une tension sur un accumulateur dans une cascade d'accumulateurs selon la revendication 1, dans lequel les étapes suivantes sont effectuées :
∘ charge d'un condensateur (C1) se trouvant au potentiel de masse jusqu'à ce que la tension (V1) d'un premier accumulateur (A1) se trouvant au potentiel de masse (GND) de la cascade d'accumulateurs se trouve, avec une précision donnée, au niveau du condensateur (C1),
∘ découplage du condensateur (C1) du potentiel de masse (GND), en particulier par commutation d'une impédance élevée entre le condensateur (C1) et le potentiel de masse (GND),
∘ application de la somme des tensions de la tension (V1) du premier accumulateur (A1) et de la tension (V2) d'un deuxième accumulateur (A2) de la cascade d'accumulateurs au condensateur (C1).

11. Procédé selon la revendication 10, dans lequel une décharge partielle du deuxième accumulateur (A2) via une résistance (R1) est réalisée comme autre étape.

12. Procédé selon la revendication 10, dans lequel une partie du courant de charge sur le deuxième accumulateur (A2) est guidée via une résistance (R1) lors d'une charge de la cascade d'accumulateurs comme autre étape.

13. Procédé selon l'une quelconque des revendications 10 à 12, dans lequel l'alimentation d'un circuit de mesure (µC) n'est réalisée que via le premier accumulateur (A1) comme autre étape.
